Europäisches Patentamt

European Patent Office

Office européen des brevets

(19)

(11) **EP 0 711 040 B1**

(12) **FASCICULE DE BREVET EUROPEEN**

(45) Date de publication et mention
de la délivrance du brevet:
**14.03.2001   Bulletin 2001/11**

(51) Int Cl.⁷: **H03L 1/02**

(21) Numéro de dépôt: **95117057.0**

(22) Date de dépôt: **30.10.1995**

(54) **Générateur de fréquence à haute stabilité**

Frequenzgenerator mit hoher Stabilität

Frequency generator with a high stability

(84) Etats contractants désignés:
**CH DE GB IT LI NL SE**

(30) Priorité:  **04.11.1994   FR 9413241**

(43) Date de publication de la demande:
**08.05.1996   Bulletin 1996/19**

(73) Titulaire: **ASULAB S.A.**
**CH-2501 Bienne (CH)**

(72) Inventeurs:
 • **Diep, Minh-Tam**
   **CH-1260 Nyon (CH)**
 • **Zellweger, Emil**
   **CH-4514 Lommiswil (CH)**
 • **Dinger, Rudolf**
   **CH-2024 St-Aubin (CH)**
 • **Farine, Pierre-André**
   **CH-2003 Neuchâtel (CH)**

(74) Mandataire: **Thérond, Gérard Raymond et al**
**I C B**
**Ingénieurs Conseils en Brevets SA**
**Rue des Sors 7**
**2074 Marin (CH)**

(56) Documents cités:
   **EP-A- 0 047 320          EP-A- 0 083 303**
   **EP-A- 0 133 388          GB-A- 2 095 005**
   **GB-A- 2 162 974**

 • **PROCEEDINGS OF THE 1992 IEEE
   INTERNATIONAL CONFERENCE ON
   INDUSTRIAL
   ELECTRONICS,CONTROL,INSTRUMENTATION
   AND AUTOMATION, 9-13 NOVEMBER,1992, SAN
   DIEGO, USA, vol. 3/3, pages 1582-1587,
   AZCONDO ET PEIRE: 'Digitally compensated
   crystal oscillator based on the self crystal as
   temperature sensor'**

## Description

La présente invention concerne un générateur de fréquence comprenant un premier oscillateur à haute fréquence, convenant par exemple pour les applications de télécommunication.

Un tel générateur peut faire partie d'un système analogique à modulation de fréquence et à bande étroite, comme on le trouve par exemple dans des téléphones cellulaires, des téléphones sans fil ou encore dans des appareils radiofréquence portatifs etc. Par ailleurs, le générateur peut également faire partie d'un système numérique comme on le trouve par exemple dans les systèmes "pager", comme les "montres-pagers". Une "montre-pager" est une montre-bracelet équipée d'un récepteur radio intégré, capable de recevoir et de traiter des messages de recherche de personnes par radiodiffusion.

Dans les générateurs de fréquence connus actuellement, l'oscillateur n'est souvent pas stabilisé, ni dans le temps ni vis-à-vis des influences de la température ambiante. Et même si cet oscillateur comporte une stabilisation, celle-ci ne sert normalement que pour compenser les influences de la température. De plus, cette compensation fonctionne en général seulement pour une plage de températures assez étroite. De tels oscillateurs thermo-compensés sont connus sous le nom TCXO (l'abréviation anglaise de Temperature Controlled Crystal Oscillator).

Toutefois, si l'on souhaite stabiliser le générateur de fréquence et son oscillateur sur une plage de températures plus large, un circuit de compensation coûteux est nécessaire. Un tel circuit est souvent considéré comme trop cher. De plus, comme cela a déjà été signalé, ce circuit de compensation compense uniquement pour les déviations de l'oscillateur dues à la variation de la température, ce qui ne suffit pas pour assurer une stabilité durable.

Pour les applications auxquelles s'adresse la présente invention, la précision en fréquence du générateur de fréquence doit être de l'ordre de $\pm 2$ à $\pm 3$ ppm ($10^{-6}$). Ceci suppose au moins l'utilisation d'un oscillateur TCXO dans le générateur. Toutefois, un oscillateur TCXO n'est pas stable dans le temps, parce que son vieillissement peut entraîner un écart en fréquence de 1 à 2 ppm ($10^{-6}$) par année. Ce vieillissement est dû au quartz de l'oscillateur, qui fournit un signal variant au cours de temps. Le vieillissement de l'oscillateur peut donc jouer un rôle important pour altérer la stabilité d'un générateur de fréquence.

Ainsi, quand l'oscillateur vieillit ou si le générateur est utilisé en dehors de la plage de températures autorisée, la variation de la fréquence de l'oscillateur du générateur de fréquence devient très importante de sorte que l'écart entre la fréquence réelle et la fréquence nominale de l'oscillateur devient trop grand. Au cas où le générateur est incorporé dans un récepteur de signaux radio par exemple, la sensibilité de ce dernier sera alors diminuée ou le signal détecté sera déformé et cette déformation produira du bruit sur le signal utile.

Le document GB 2 095 005 décrit une montre électronique. La montre comprend un oscillateur basse fréquence commandé par un premier résonateur à quartz pour produire un signal de base de temps, suivi par un diviseur de fréquence de la base de temps pour définir un signal d'unité de temps à afficher sur un écran. Elle comprend encore un oscillateur haute fréquence commandé par un second résonateur à quartz, des moyens de mesure de la température produisant des signaux de données de température d'opération à la montre, et des moyens comparateur pour comparer les fréquences provenant de l'oscillateur haute fréquence et de l'oscillateur basse fréquence afin de détecter une erreur de fréquence du signal d'unité de temps par rapport à une valeur prédéterminée qui a une relation par rapport au signal haute fréquence.

Des compensations de la température et du vieillissement pour l'oscillateur basse fréquence sont prévues grâce à l'oscillateur haute fréquence qui est stable et enclenché par intermittence par un circuit de commande selon des mesures de température pour fournir un signal de fréquence au comparateur.

Il est donc nécessaire de stabiliser efficacement l'oscillateur du générateur de fréquence, de préférence avec un circuit de compensation peu coûteux par rapport au prix de générateur dans son ensemble.

Le but de la présente invention est d'apporter une solution à ce problème en fournissant un générateur de fréquence peu coûteux qui soit très stable, même sur une longue période de temps, et qui soit indépendant de l'influence de la température.

Ce but est atteint grâce à un générateur de fréquence à haute stabilité comprenant un premier oscillateur destiné à engendrer une première fréquence corrigée à l'aide d'un circuit de correction, caractérisé en ce qu'il comprend en outre :

- une base de temps comprenant un deuxième oscillateur destiné à engendrer une deuxième fréquence, et des moyens de compensation de ce deuxième oscillateur, cette base de temps fournissant un signal de fréquence stable dans le temps et indépendant de la température,
- des moyens pour définir un intervalle de temps déterminé par ledit signal de fréquence stable, et
- des moyens d'asservissement comprenant :
- un compteur agencé pour compter un premier nombre d'impulsions venant dudit premier oscillateur durant ledit intervalle de temps, et agencé pour fournir le premier nombre à des moyens de comparaison associés audit compteur,
- des moyens pour fournir un nombre d'impulsions de référence auxdits moyens de comparaison, et
- des moyens pour fournir un signal de correction en fonction de la différence entre ledit premier nombre et ledit nombre de référence, ce signal de correction commandant le circuit de correction de la première fréquence d'oscillation.

Ce but est également atteint grâce à un générateur de fréquence à haute stabilité comprenant un premier oscillateur destiné à engendrer une première fréquence corrigée à l'aide d'un circuit de correction, caractérisé en ce qu'il comprend en outre :

- une base de temps comprenant un deuxième oscillateur destiné à engendrer une deuxième fréquence, et des moyens de compensation de ce deuxième oscillateur fournissant un nombre de correction $N_x$ d'impulsions représentatif d'une correction à exécuter, cette base de temps fournissant un signal de fréquence stable dans le temps et indépendant de la température,
- des moyens pour définir un intervalle de temps déterminé par ledit deuxième oscillateur, et
- des moyens d'asservissement comprenant :
- un compteur agencé pour compter un premier nombre d'impulsions venant dudit premier oscillateur durant ledit intervalle de temps et agencé pour fournir le premier nombre d'impulsions à des moyens d'additionneurs agencés pour calculer la somme dudit premier nombre et dudit nombre de correction,
- des moyens de comparaison agencés pour recevoir ladite somme fournie par lesdits moyens de calcul,
- des moyens pour fournir un nombre d'impulsions de référence auxdits moyens de comparaison, et
- des moyens pour fournir un signal de correction en fonction de la différence entre ladite somme et ledit nombre de référence, ce signal de correction commandant le circuit de correction de la première fréquence d'oscillation.

La solution préconisée par l'invention consiste à asservir l'oscillateur fournissant la fréquence utile à un deuxième oscillateur ou oscillateur de référence qui a une grande stabilité grâce au fait qu'il est thermo-compensé et qu'il comporte un circuit de compensation électronique de son vieillissement conçu selon un principe connu dans la technique horlogère pour assurer ce que les spécialistes appellent "la convergence de marche".

Avantageusement, un tel générateur à haute stabilité selon l'invention peut être utilisé dans des pièces d'horlogerie telles que des montres-pagers.

On va décrire ci-après, à titre d'exemple uniquement, deux modes de réalisation de l'objet de l'invention en se référant aux dessins annexés, dans lesquels :

- la figure 1 représente un schéma d'une base de temps à grande stabilité qui peut être utilisée dans le générateur selon l'invention;
- la figure 2 représente un diagramme temporel sur un intervalle de temps $I_T$ montrant les corrections à exécuter;
- la figure 3 représente un schéma du générateur de l'invention selon un premier mode de réalisation; et
- la figure 4 représente un schéma du générateur de l'invention selon un deuxième mode de réalisation.

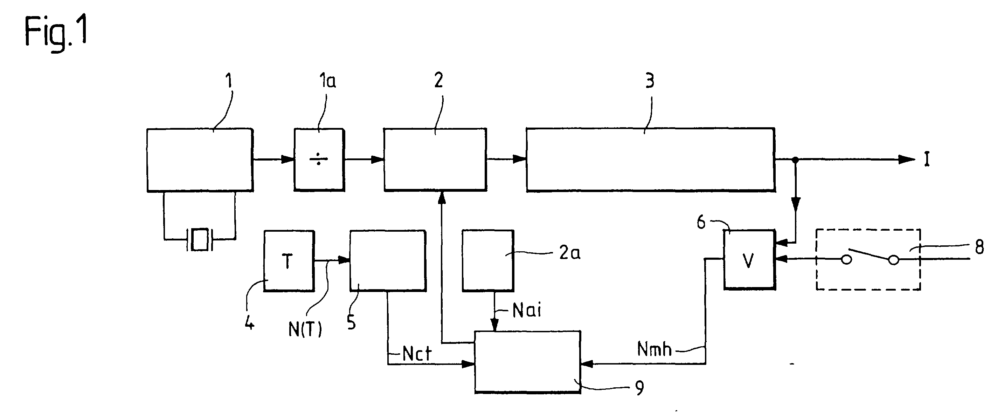

La figure 1 est un schéma représentant une base de temps à haute stabilité comprenant un oscillateur à basse fréquence 1, par exemple un oscillateur horloger piloté par un résonateur à quartz et qui est apte à fournir un signal de sortie ayant une fréquence nominale de 32 768 Hz. Cet oscillateur 1 est couplé à un circuit d'inhibition 2 par l'intermédiaire d'un premier diviseur 1a. Le circuit d'inhibition 2 est associé à un circuit électronique comportant une chaîne de division 3, susceptible de transformer le signal de sortie fourni par le circuit d'inhibition 2 en un signal divisé I dont la fréquence est adaptée aux besoins. Par exemple, dans le cas d'une montre telle qu'une montre-pager, le diviseur 1a et la chaîne de division 3 présentent ensemble un taux de division égal à 32 768 de sorte que le signal I a une fréquence de 1Hz, lorsque le signal fourni par l'oscillateur 1 a sa fréquence nominale et que le circuit d'inhibition 2 ne supprime aucune impulsion. Le signal I peut être utilisé pour commander un moteur pas-à-pas couplé à un rouage pour entraîner des moyens d'affichage.

Cependant, la fréquence réelle délivrée par le quartz de l'oscillateur à basse fréquence 1 change dans le temps et dépend de la température ambiante. Par exemple, pour un oscillateur horloger dont le quartz vibre à sa fréquence nominale à une température de 25° C, l'erreur de cette fréquence peut atteindre 20 ppm ou plus dans une plage de température de -10 à +50° C.

Il est donc nécessaire de compenser l'effet de la température sur la fréquence délivrée par le quartz de l'oscillateur à basse fréquence 1.

On a proposé plusieurs systèmes pour la compensation thermique d'une base de temps, par exemple dans le brevet américain US-A-4 761 771 ou le brevet suisse CH-B-650 122.

Dans la base de temps de la figure 1, cette compensation est effectuée selon le principe décrit dans le brevet US-A-4 761 771.

Selon ce principe, le circuit d'inhibition 2 supprime périodiquement un nombre $N_{ct}$ et un nombre $N_{ai}$ d'impulsions du signal fourni par le diviseur 1a, et ceci avec une périodicité de $I_T$ secondes.

Le nombre $N_{ct}$ est le nombre d'impulsions à supprimer pour que la fréquence du signal I soit indépendant de la température, et il est produit par un circuit de correction 5 qui reçoit une information N(T) d'un capteur 4 sensible à la température.

Le nombre $N_{ai}$ est le nombre d'impulsions à supprimer pour tenir compte d'une erreur volontaire faite, lors de la fabrication du résonateur de l'oscillateur 1, sur sa fréquence maximale, et il est enregistré dans une mémoire 2a.

Un multiplexeur 9 fournit successivement le nombre $N_{ct}$ et le nombre $N_{ai}$ au circuit d'inhibition 2.

La fréquence du signal fourni par l'oscillateur 1 change également à cause du vieillissement de son quartz.

Dans la base de temps de la figure 1, la compensation de ce vieillissement est réalisée selon le principe connu sous le nom de "convergence de marche" et décrit dans le brevet suisse CH-B-599 609.

En résumé, pour corriger la fréquence du signal I, il faut premièrement enlever un nombre $N_{ai}$ invariable d'impulsions pour tenir compte de l'ajustement initial (erreur voulue), deuxièmement un nombre $N_{ct}$ variable d'impulsions pour tenir compte de la variation de la fréquence de l'oscillateur 1 due à la température, et troisièmement un nombre $N_{mh}$, également variable, d'impulsions pour tenir compte du vieillissement du quartz de l'oscillateur 1.

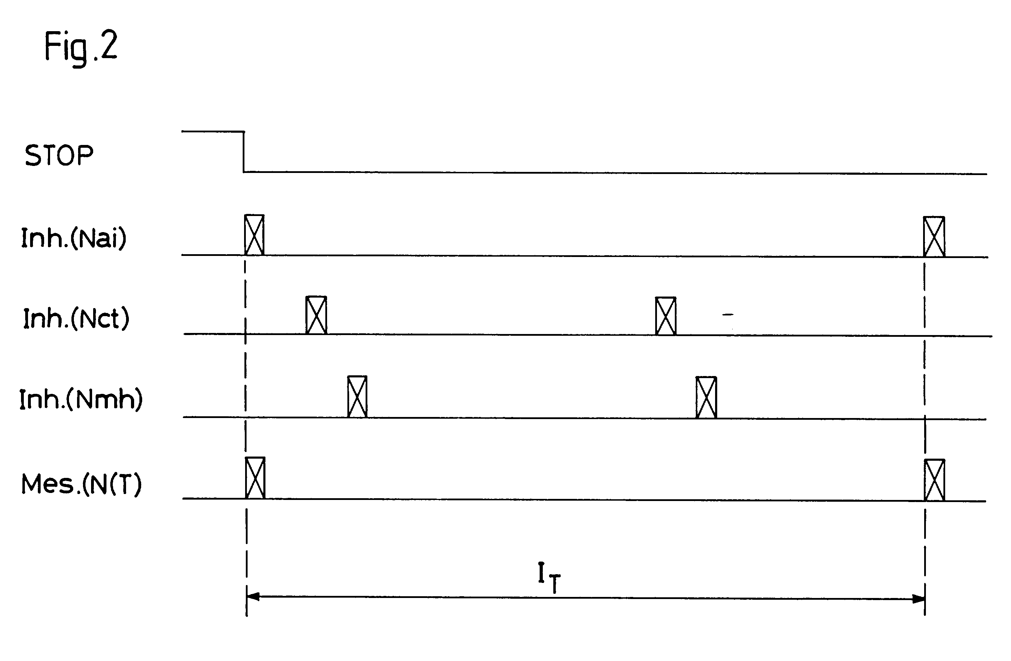

Ces différents nombres sont fournis successivement au circuit d'inhibition 2 par le multiplexeur 9, d'une manière dont un exemple est illustré par la figure 2. On voit que dans cet exemple, le multiplexeur 9 fournit le nombre $N_{ai}$ au circuit d'inhibition 2 au début de chaque période $I_T$. Simultanément, le capteur 4 mesure la température et transmet le signal N(T) au circuit 5. Ce dernier détermine alors le nombre $N_{ct}$, qui est ensuite transmis au circuit d'inhibition 2 par le multiplexeur 9. Un instant plus tard, ce multiplexeur 9 transmet le nombre $N_{mh}$ au circuit d'inhibition 2.

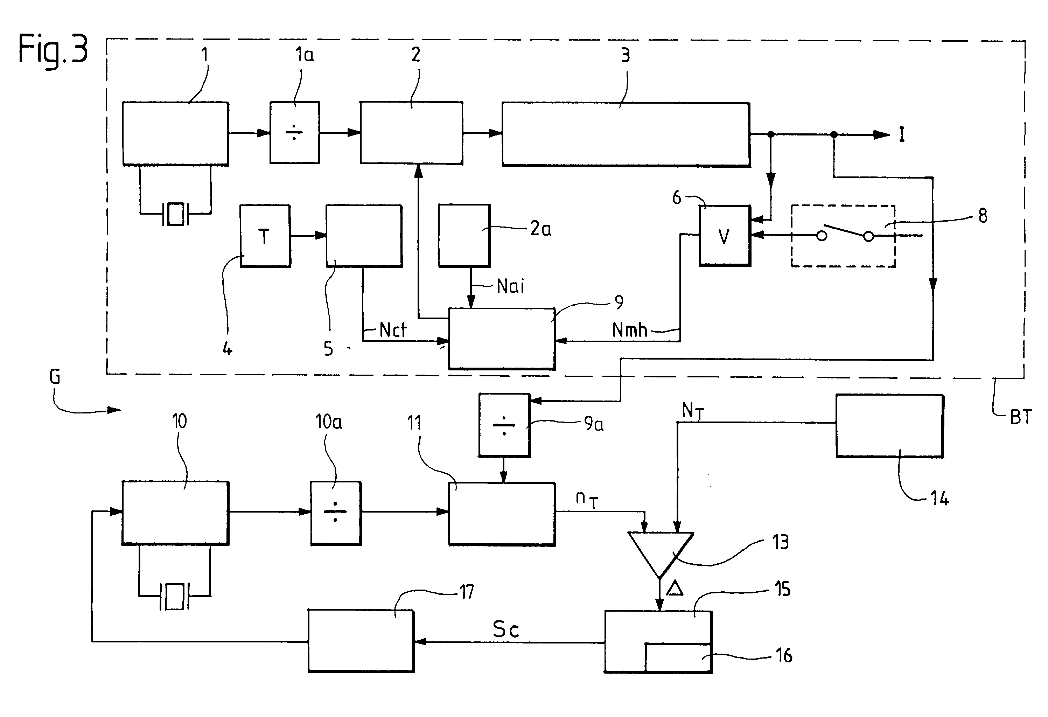

La figure 3 représente un schéma du générateur G de l'invention selon un premier mode de réalisation.

Le générateur G comprend tout d'abord un circuit BT tel que celui qui est représenté à la figure 1. Le générateur de fréquence G comprend en outre un oscillateur à haute fréquence 10 qui peut faire partie par exemple d'un récepteur radio capable de recevoir des messages radiodiffusés. Un tel récepteur peut être utilisé dans les montres-pagers, par exemple.

La fréquence F1 engendrée par l'oscillateur à haute fréquence 10 dépend de la température ambiante et varie dans le temps, de même que celle engendrée par l'oscillateur 1.

Pour stabiliser cet oscillateur 10 un circuit d'asservissement est incorporé dans le générateur G selon l'invention.

Afin de pouvoir réguler la fréquence F1 de l'oscillateur 10, cette fréquence F1 du signal de sortie de l'oscillateur 10 doit d'abord être mesurée.

Pour des raisons pratiques, le signal de sortie de cet oscillateur 10 passe par un diviseur 10a afin d'atteindre une fréquence plus basse facilitant la mesure.

Ensuite, le signal de sortie du diviseur 10a est appliqué à un compteur 11 qui compte pendant un certain intervalle de temps T un nombre $n_T$ d'impulsions parvenant de ce diviseur 10a. Le nombre $n_T$ est donc une indication de mesure de la fréquence F1 fournie par l'oscillateur à haute fréquence 10. La sortie du compteur 11 est associée à un comparateur 13 pour comparer le nombre d'impulsions compté par le compteur 11 pendant l'intervalle de temps T à un nombre d'impulsions de référence fourni par une mémoire 14, également associée au comparateur 13. La sortie du comparateur 13 est associée à des moyens d'évaluation 15 comprenant également une mémoire 16. Les moyens 15 produisent un signal de commande Sc pour commander un circuit de correction 17 associé à l'oscillateur à haute fréquence 10 pour modifier la fréquence de son signal de sortie.

La durée de la mesure, l'intervalle T, est déterminée par la base de temps BT stabilisée. En effet, le signal I de sortie de la base de temps BT stabilisée est utilisé pour commander le compteur 11. A cet effet, la base de temps BT fournit le signal I de fréquence stable au compteur 11 par l'intermédiaire d'un diviseur 9a qui divise la fréquence de ce signal I afin d'obtenir un signal de commande du compteur 11 ayant une période égale à la durée de l'intervalle T désiré. Par exemple, si le signal de sortie de la base de temps BT est un signal à une fréquence de 1 Hz, et si la durée désiré de l'intervalle T est de 8s, le diviseur 9a divise le signal I par 8 afin d'obtenir un signal sortant du diviseur 9a ayant une fréquence de 1/8 Hz correspondant à des impulsions espacées dans le temps de 8s. La première impulsion du signal sortant du diviseur 9a peut être un signal de commande qui enclenche le compteur 11 afin de commencer la mesure, tandis que la deuxième impulsion, arrivant T secondes plus tard (ici T=8s), peut être une commande de déclenchement du compteur 11 arrêtant ainsi la mesure.

Le résultat de mesure du compteur 11 est alors un nombre d'impulsions compté pendant l'intervalle T. Le compteur 11 fournit ensuite ce nombre d'impulsions $n_T$ au comparateur 13. Le nombre $n_T$ d'impulsions est comparé à un nombre d'impulsions de référence $N_T$ stocké dans la mémoire 14, qui est prédéterminé et dépend du nombre d'impulsions que l'oscillateur 10 aurait dû produire dans l'intervalle T.

Les moyens de comparaison 13 déterminent la différence $\Delta = |n_T - N_T|$, qui est donc représentative de la correction à exécuter pour corriger la fréquence F1 de l'oscillateur à haute fréquence 10. A cet effet, cette valeur $\Delta$ est appliquée à des moyens d'évaluation 15 qui comportent une table de consigne stockée dans une mémoire 16 et qui fournissent, pour chaque valeur de $\Delta$ possible, un signal de correction Sc correspondant. Ainsi, la valeur de $\Delta$ détermine la correction nécessaire comme cela sera expliqué ci-après.

Le signal de correction Sc est un signal de commande pouvant être appliqué au circuit de correction 17 pour modifier la fréquence F1 du signal de sortie de l'oscillateur 10. Le circuit de correction 17 comporte par exemple un réseau de capacités commutables connecté en parallèle avec le circuit d'oscillation de l'oscillateur 10. Le signal de correction Sc commande le branchement de capacités du circuit de correction 17 pour que la fréquence F1 de l'oscillateur 10 ait la valeur voulue. Un réseau de capacités commutables ainsi que sa connexion sont connus de l'homme du métier et ne seront donc pas expliqués plus en détail ici.

On comprend ainsi que la fréquence F1 du signal de sortie de l'oscillateur 10 peut être modifiée et donc stabilisée en fonction des informations fournies par la base de temps BT fonctionnant ainsi comme oscillateur de référence de la boucle d'asservissement de l'oscillateur à haute fréquence 10.

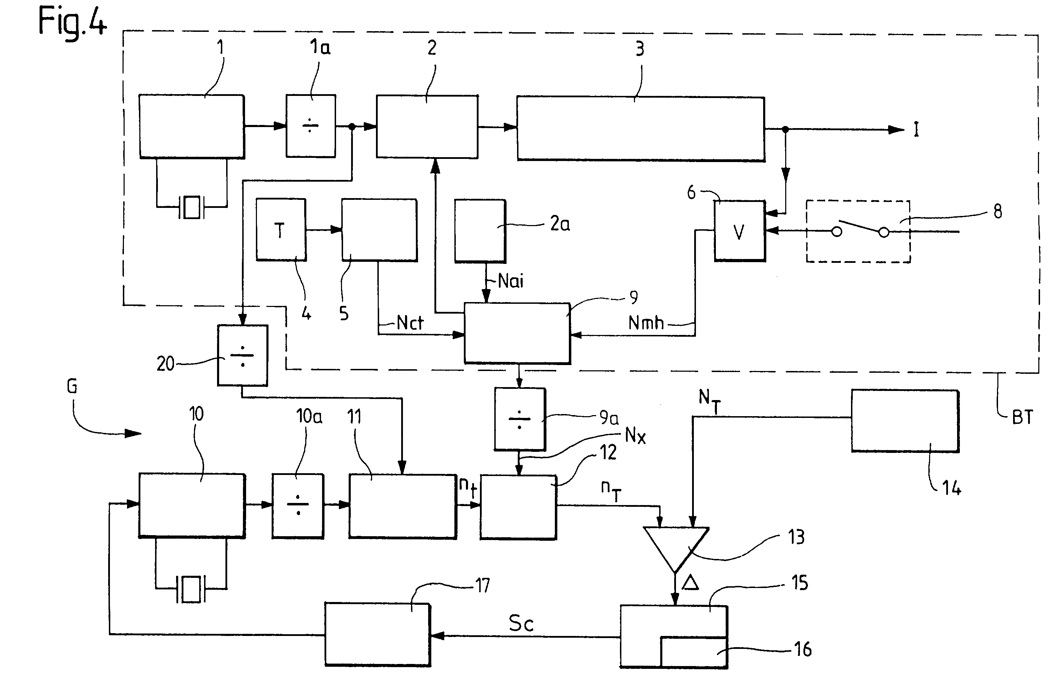

La figure 4 représente un schéma du générateur de l'invention selon un deuxième mode de réalisation.

Ce mode de réalisation correspond largement au premier mode de la figure 3, c'est-à-dire qu'un diviseur 10a, associé à l'oscillateur 10, est connecté a un compteur 11. Toutefois, ici le compteur 11 est associé à des moyens de calcul 12, par exemple un additionneur. Les moyens de calcul 12 sont associés à un comparateur 13, auquel est également associée une mémoire 14. La sortie du comparateur passe dans des moyens d'évaluation 15 comportant une mémoire 16 et fournissant un signal de sortie de commande Sc à un circuit de correction 17. Le circuit de correction 17 est associé au circuit d'oscillation de l'oscillateur à haute fréquence 10 pour modifier la fréquence F1 du signal de sortie de l'oscillateur 10.

Dans ce deuxième mode de réalisation, le compteur 11 n'est pas commandé par le signal de sortie I de la base de temps BT stabilisée, mais il est commandé uniquement par le signal de sortie du diviseur 1a qui détermine au moyen d'un diviseur 20 la durée d'activité du compteur 11. Comme la fréquence du signal de sortie de l'oscillateur 1, et donc la fréquence du signal de sortie du diviseur 1a, n'est pas stable en soi, elle engendre une erreur de la durée du temps de mesure. Ce temps de mesure a alors une durée t et non plus T comme cela est le cas dans le premier mode. L'erreur (l'écart entre t et T) causée par les variations dues à la température, au vieillissement et à l'ajustage initial du résonateur de l'oscillateur 1, peut être corrigée par les informations de compensation $N_{ct}$, $N_{mh}$ et $N_{ai}$ fournies au multiplexeur 9. Ainsi, l'erreur de mesure due à la durée de l'intervalle t peut être corrigée.

A cet effet, le multiplexeur 9 est raccordé à un circuit de calcul 9a pour fournir une valeur de correction $N_x$ comme expliqué ci-après.

En effet, le compteur 11 compte pendant l'intervalle t un nombre $n_t$ d'impulsions qui lui parvient de l'oscillateur à haute fréquence 10 par l'intermédiaire du diviseur 10a. Toutefois, le compteur 11 n'a pas compté pendant T secondes, mais pendant t secondes. C'est-à-dire, si t<T, le compteur 11 n'a pas compté assez longtemps, et il faut alors additionner un nombre $N_x$ d'impulsions de correction au résultat $n_t$ du comptage; par contre, si t>T, le compteur a compté trop longtemps, et il faut soustraire ce nombre $N_x$ d'impulsions du nombre $n_t$.

A cet effet, les trois valeurs $N_{ai}$, $N_{ct}$, $N_{mh}$ appliquées au multiplexeur 9 passent dans un circuit arithmétique 9a agencé de manière à les adapter aux conditions de la boucle à haute fréquence en effectuant les corrections nécessaires pour tenir compte de la différence entre la fréquence F2 de l'oscillateur à basse fréquence 1 et la fréquence F1 de l'oscillateur à haute fréquence 10, de la différence entre l'intervalle $I_T$ de mesure de compensation de la base de temps BT et l'intervalle T de mesure souhaité, et de l'intervalle t de mesure réel de la fréquence F1. De plus, si les diviseurs 1a et 10a n'ont pas le même taux de division, une correction pour le rapport entre leurs taux est encore nécessaire.

Plus précisément, le circuit arithmétique 9a peut être agencé de manière à calculer le nombre de correction $N_x$ à l'aide de l'équation suivante :

$$N_x = N_{ai} \cdot \frac{F1 \cdot T \cdot d2}{F2 \cdot I_T \cdot d1} + (N_{ct} + N_{mh}) \cdot \frac{F1 \cdot T \cdot d2}{F2 \cdot t \cdot d1}$$

dans laquelle d1 et d2 sont respectivement les taux de division des diviseurs 10a et 1a, et t est la durée de mesure réelle de la fréquence F1.

On comprend que le nombre $N_x$ peut être positif ou négatif, selon les valeurs de $N_{ct}$ et $N_{ai}$ (toujours positifs), d'une part, et $N_{mh}$ (positif ou négatif), d'autre part.

Ensuite, les moyens de calcul 12 additionnent le nombre $N_x$ calculé par le circuit arithmétique 9a au nombre $n_t$ d'impulsions reçu du compteur 11 pour obtenir un nombre d'impulsions $n_T = n_t + N_x$ .

Le résultat $n_T$ de cette addition est comparé par les moyens de comparaison 13 au nombre $N_T$ d'impulsions de référence, comme dans le mode de réalisation de la figure 3.

La différence $|n_T-N_T|=\Delta$ déterminée par cette comparaison est traitée par les moyens 15 et 16 de la même façon que dans le premier mode de réalisation afin d'engendrer un signal de correction. C'est-à-dire, ici aussi, les moyens d'évaluation 15 engendrent un signal de correction Sc pour commander le circuit de correction 17 afin de modifier la fréquence F1 du signal de sortie de l'oscillateur 10 afin de le stabiliser, comme décrit ci-dessus dans le cas du premier mode de la figure 3.

Comme cela a été expliqué ci-dessus, le générateur G selon l'invention peut avantageusement être incorporé dans une montre-pager. La base de temps BT du générateur G est alors associée aux moyens d'affichage de la montre-pager, et l'oscillateur à haute fréquence (10) du générateur G est utilisé en tant que récepteur radio des messages. Ainsi, la montre-pager a une base de temps stable ainsi qu'un récepteur radio stabilisé grâce au générateur de fréquences G de l'invention.

## Revendications

1. Générateur de fréquence (G) à haute stabilité comprenant un premier oscillateur (10) destiné à engendrer une première fréquence (F1), corrigée à l'aide d'un circuit de correction (17), caractérisé en ce qu'il comprend en outre :

- une base de temps (BT) comprenant un deuxième oscillateur (1) destiné à engendrer une deuxième fréquence (F2), et des moyens de compensation (4, 5, 6) de ce deuxième oscillateur, cette base de temps (BT) fournissant un signal de fréquence stable dans le temps et indépendant de la température,
- des moyens (9a) pour définir un intervalle de temps (T) déterminé par ledit signal de fréquence stable, et
- des moyens d'asservissement comprenant :
- un compteur (11) agencé pour compter un premier nombre d'impulsions ($n_T$) venant dudit premier oscillateur (10) durant ledit intervalle de temps (T), et agencé pour fournir le premier nombre ($n_T$) à des moyens de comparaison (13) associés audit compteur (11),
- des moyens (14) pour fournir un nombre d'impulsions de référence ($N_T$) auxdits moyens de comparaison (13), et
- des moyens (13, 15, 16) pour fournir un signal de correction (Sc) en fonction de la différence ($\Delta$) entre ledit premier nombre ($n_T$) et ledit nombre de référence ($N_T$), ce signal de correction (Sc) commandant le circuit de correction (17) de la première fréquence d'oscillation (F1).

2. Générateur de fréquence (G) à haute stabilité comprenant un premier oscillateur (10) destiné à engendrer une première fréquence (Fl) corrigée à l'aide d'un circuit de correction (17), caractérisé en ce qu'il comprend en outre :

- une base de temps (BT) comprenant un deuxième oscillateur (1) destiné à engendrer une deuxième fréquence (F2), et des moyens de compensation (4, 5, 6, 9, 9a) de ce deuxième oscillateur (1) fournissant un nombre de correction ($N_x$) d'impulsions représentatif d'une correction à exécuter, cette base de temps (BT) fournissant un signal de fréquence stable dans le temps et indépendant de la température,
- des moyens (20) pour définir un intervalle de temps (t) déterminé par ledit deuxième oscillateur (1), et
- des moyens d'asservissement comprenant :
- un compteur (11) agencé pour compter un premier nombre d'impulsions ($n_t$) venant dudit premier oscillateur (10) durant ledit intervalle de temps (t) et agencé pour fournir le premier nombre d'impulsions (nt) à des moyens d'additionneurs (12) agencés pour calculer la somme ($n_T$) dudit premier nombre ($n_t$) et dudit nombre

de correction ($N_x$),
- des moyens de comparaison (13) agencés pour recevoir ladite somme ($n_T$) fournie par lesdits moyens de calcul (12),
- des moyens (14) pour fournir un nombre d'impulsions de référence ($N_T$) auxdits moyens de comparaison (13), et
- des moyens (15, 16) pour fournir un signal de correction (Sc) en fonction de la différence ($\Delta$) entre ladite somme ($n_T$) et ledit nombre de référence ($N_T$), ce signal de correction (Sc) commandant le circuit de correction (17) de la première fréquence d'oscillation (F1).

3. Générateur selon la revendication 1 ou 2, caractérisé en ce que les moyens de compensation (4, 5, 6, 9) dudit deuxième oscillateur (1) comportent :

- un circuit de compensation thermique (4, 5) de ladite base de temps, et
- un circuit de compensation du vieillissement (6, 8) de ladite base de temps.

4. Générateur selon la revendication 1, 2 ou 3, caractérisé en ce que le circuit de correction (17) est constitué d'un réseau de capacités commutables comprenant une ou plusieurs capacités, chacune pouvant être branchée en parallèle avec le circuit d'oscillation du premier oscillateur (10) pour modifier sa fréquence (F1).

5. Pièce d'horlogerie capable de recevoir des messages radiodiffusés comprenant au moins des moyens d'affichage d'une information horaire (I) et des moyens de réception desdits messages, caractérisée en ce que ladite pièce comprend en outre un générateur (G) de fréquence selon l'une quelconque des revendications précédentes, ledit signal fourni par ladite base de temps (BT) étant associé auxdits moyens d'affichage, et en ce que lesdits moyens de réception comprennent en outre ledit premier oscillateur (10) comme récepteur radio desdits messages.

**Patentansprüche**

1. Frequenzgenerator (G) mit hoher Stabilität, umfassend einen ersten Oszillator (10), der dazu bestimmt ist, eine erste Frequenz (F1) zu erzeugen, die mit Hilfe einer Korrekturschaltung (17) korrigiert wird, dadurch gekennzeichnet, daß er außerdem umfaßt:

- eine Zeitbasis (BT), die einen zweiten Oszillator (1), der dazu bestimmt ist, eine zweite Frequenz (F2) zu erzeugen, sowie Kompensationsmittel (4, 5, 6) für diesen zweiten Oszillator umfaßt, wobei diese Zeitbasis (BT) ein Frequenzsignal liefert, das zeitlich stabil und temperaturunabhängig ist,

- Mittel (9a), die ein Zeitintervall (T) definieren, das durch das stabile Frequenzsignal bestimmt wird, und
- Regelungsmittel, die umfassen:
- einen Zähler (11), der so ausgebildet ist, daß er eine erste Anzahl ($n_T$) von Impulsen zählt, die während des Zeitintervalls (T) vom ersten Oszillator (10) ankommen, und so ausgebildet ist, daß er die erste Anzahl ($n_T$) an Vergleichsmittel (13) liefert, die dem Zähler (11) zugeordnet sind,
- Mittel (14), die eine Referenzanzahl ($N_T$) von Impulsen an die Vergleichsmittel (13) liefern, und
- Mittel (13, 15, 16), die ein Korrektursignal (Sc) in Abhängigkeit von der Differenz (A) zwischen der ersten Anzahl ($n_T$) und der Referenzanzahl ($N_T$) liefern, wobei dieses Korrektursignal (Sc) die Korrekturschaltung (17) für die erste Oszillationsfrequenz (F1) steuert.

2. Frequenzgenerator (G) mit hoher Stabilität, der einen ersten Oszillator (10) umfaßt, der dazu bestimmt ist, eine erste Frequenz (F1) zu erzeugen, die mit Hilfe einer Korrekturschaltung (17) korrigiert wird, dadurch gekennzeichnet, daß er außerdem umfaßt:

- eine Zeitbasis (BT), die einen zweiten Oszillator (1), der dazu bestimmt ist, eine zweite Frequenz (F2) zu erzeugen, sowie Kompensationsmittel (4, 5, 6, 9, 9a) für diesen zweiten Oszillator (1), die eine Korrekturanzahl($N_x$) von Impulsen liefern, die eine auszuführende Korrektur repräsentieren, umfaßt, wobei diese Zeitbasis (BT) ein Frequenzsignal liefert, das zeitlich stabil und temperaturunabhängig ist,
- Mittel (20) zum Definieren eines Zeitintervalls (t), das durch den zweiten Oszillator (1) bestimmt wird, und
- Regelungsmittel, die umfassen:
- einen Zähler (11), der so ausgebildet ist, daß er eine erste Anzahl ($n_t$) von Impulsen zählt, die während des Zeitintervalls (t) vom ersten Oszillator (10) ankommen, und so ausgebildet ist, daß er die erste Anzahl ($n_t$) von Impulsen an Addierermittel (12) liefert, die so ausgebildet sind, daß sie die Summe ($n_T$) aus der ersten Anzahl ($n_t$) und aus der Korrekturanzahl ($N_x$) berechnen,
- Vergleichsmittel (13), die so ausgebildet sind, daß sie die von den Rechenmitteln (12) gelieferte Summe ($n_T$) empfangen,
- Mittel (14), die eine Referenzanzahl ($N_T$) von Impulsen an die Vergleichsmittel (13) liefern, und
- Mittel (15, 16), die ein Korrektursignal (Sc) in Abhängigkeit von der Differenz (A) zwischen der Summe ($n_T$) und der Referenzanzahl ($N_T$) liefern, wobei dieses Korrektursignal (Sc) die Korrekturschaltung (17) für die erste Oszillationsfrequenz (F1) steuert.

3. Generator nach Anspruch 1 oder 2, dadurch gekennzeichnet, daß die Kompensationsmittel (4, 5, 6, 9) des zweiten Oszillators (1) umfassen:

- eine thermische Kompensationsschaltung (4, 5) für die Zeitbasis, und
- eine Alterungskompensationsschaltung (6, 8) für die Zeitbasis.

4. Generator nach Anspruch 1, 2 oder 3, dadurch gekennzeichnet, daß die Korrekturschaltung (17) aus einem Netzwerk schaltbarer Kapazitäten gebildet ist, das eine oder mehrere Kapazitäten enthält, wovon jede zur Oszillationsschaltung des ersten Oszillators (10) parallelgeschaltet werden kann, um dessen Frequenz (F1) zu modifizieren.

5. Zeitmeßgerät, das über Rundfunk gesendete Nachrichten empfangen kann und wenigstens Mittel zum Anzeigen einer Zeitinformation (I) und Mittel zum Empfang der Nachrichten umfaßt, dadurch gekennzeichnet, daß das Gerät außerdem einen Frequenzgenerator (G) nach einem der vorhergehenden Ansprüche umfaßt, wobei das von der Zeitbasis (BT) gelieferte Signal den Anzeigemitteln zugeordnet ist, und daß die Empfangsmittel außerdem den ersten Oszillator (10) als Funkempfänger für die Nachrichten umfassen.

**Claims**

1. High stability frequency generator (G) comprising a first oscillator (10) intended to generate a first frequency (F1) corrected by means of a correction circuit (17), characterized in that it further comprises :

- a time base (BT) comprising a second oscillator (1) intended to generate a second frequency (F2), and compensation means (4, 5, 6) of the second oscillator, this time base (BT) providing a frequency signal which is stable in time and which is independent of the temperature,
- means (9a) for defining a time interval (T) determined by said stable frequency signal, and
- feedback means comprising :
- a counter (11) arranged to count a first number ($n_T$) of pulses coming from said first oscillator (10) during said time interval (T), and arranged to provide the first number ($n_T$) to comparing means (13) associated to said counter (11),

- means (14) for providing a reference number ($N_T$) of pulses to said comparing means (13), and
- means (13, 15, 16) for providing a correction signal (Sc) as a function of the difference ($\Delta$) between said first number ($n_T$) and said reference number ($N_T$), this correction signal (Sc) controlling the correction circuit (17) of the oscillation frequency (F1).

2. High stability frequency generator (G) comprising a first oscillator (10) intended to generate a first frequency (F1) corrected by means of a correction circuit (17), characterized in that it further comprises :

- a time base (BT) comprising a second oscillator (1) intended to generate a second frequency (F2), and compensation means (4, 5, 6, 9, 9a) of this second oscillator (1) providing a number of correction pulses ($N_x$) representative of a correction to be performed, this time base (BT) providing a frequency signal which is stable in time and which is independent of the temperature,
- means (20) for defining a time interval (t) determined by said second oscillator (1), and
- feedback means comprising :
- a counter (11) arranged to count a first number ($n_t$) of pulses coming from said first oscillator (10) during said time interval (t) and arranged to provide the first number ($n_t$) of pulses to adding means (12) which are arranged to calculate the sum ($n_T$) of said first number ($n_t$) and said correction number ($N_x$),
- comparing means (13) arranged to receive said sum ($n_T$) provided by said calculating means (12),
- means (14) intended to provide a reference number ($N_T$) of pulses to said comparing means (13), and
- means (15, 16) for providing a correction signal (Sc) as a function of the difference ($\Delta$) between said sum ($n_T$) and said reference number ($N_T$), this correction signal (Sc) controlling the correction circuit (17) of the oscillation frequency (F1).

3. Generator according to claim 1 or 2, characterized in that the compensation means (4, 5, 6, 9) of said second oscillator (1) comprise :

- a temperature compensation circuit (4,5) of said time base, and
- an ageing compensation circuit (6,8) of said time base.

4. Generator according to claim 1, 2 or 3, characterized in that the correction circuit (17) is constituted by an network of switchable capacitors comprising one or several capacities, each been connectable in parallel to the oscillation circuit of said first oscillator (10) so as to modify its frequency (F1).

5. Timepiece capable of receiving radio-diffused messages comprising at least display means for displaying a time information (I) and receiving means for receiving said messages, characterized in that said timepiece further comprises a frequency generator (G) according to any one of the preceding claims, said frequency signal provided by said time base (BT) being associated to said display means, and in that said receiving means further comprise said first oscillator (10) as a radio receiver for said messages.

# Fig.1

EP 0 711 040 B1

# Fig.2

STOP

Inh.(Nai)

Inh.(Nct)

Inh.(Nmh)

Mes.(N(T))

$I_T$

EP 0 711 040 B1

Fig.3

EP 0 711 040 B1

Fig.4